Europäisches Patentamt

European Patent Office

Office européen des brevets

(19)

(11) Veröffentlichungsnummer: **0 204 376 B1**

(12) **EUROPÄISCHE PATENTSCHRIFT**

(45) Veröffentlichungstag der Patentschrift: **14.10.92**

(51) Int. Cl.⁵: $H03K\ 5/156$, $H03M\ 5/16$

(21) Anmeldenummer: **86200957.8**

(22) Anmeldetag: **02.06.86**

(54) **Schaltungsanordnung zur Abtastung eines ternären Signales.**

(30) Priorität: **04.06.85 DE 3519929**

(43) Veröffentlichungstag der Anmeldung:
**10.12.86 Patentblatt  86/50**

(45) Bekanntmachung des Hinweises auf die
Patenterteilung:
**14.10.92 Patentblatt  92/42**

(84) Benannte Vertragsstaaten:
**AT BE CH DE FR GB IT LI NL SE**

(56) Entgegenhaltungen:
**DE-B- 2 827 958**
**US-A- 3 764 989**
**US-A- 3 864 529**
**US-A- 4 080 572**
**US-A- 4 242 755**

**ELECTRONICS, Band 6, Nr. 5, 1. März 1973,**
**Seiten 94-96, New York, US; T.R. BLAKESLEE:**
**"Transformer-coupled transceiver speeds**
**two-way data transmission"**

(73) Patentinhaber: **Philips Patentverwaltung**
**GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfa-**
**brieken**
**Groenewoudseweg 1**
**NL-5621 BA Eindhoven(NL)**

(84) Benannte Vertragsstaaten:
**BE CH FR GB IT LI NL SE AT**

(72) Erfinder: **Loscher, Jürgen, Dipl.-Ing. FH**
**Waldstrasse 1a**
**W-8561 Reichenschwand(DE)**

(74) Vertreter: **Peuckert, Hermann, Dipl.-Ing. et al**
**Philips Patentverwaltung GmbH Wenden-**
**strasse 35 Postfach 10 51 49**
**W-2000 Hamburg 1(DE)**

EP 0 204 376 B1

**Beschreibung**

Die Erfindung betrifft eine Schaltungsanordnung zur Abtastung eines ternären Signales, bei der das ternäre Signal an die Eingänge zweier Fensterkomparatoren geführt ist und seine größten Amplituden in das Fenster des ersten und seine kleinsten Amplituden in das Fenster des zweiten Fensterkomparators fallen.

Eine Schaltungsanordnung dieser Art kann z.B. in Regeneratoren verwendet werden, mit denen Alternate Mark Inversion-codierte (AMI-codierte) Leitungssignale regeneriert werden sollen.

Aus der DE-A-2827 958 ist ein Regenerator bekannt, bei dem zur Regeneration eines n-ären Signals mit n Amplitudenstufen, n-1 Amplitudenentscheider (Fensterkomparatoren) verwendet werden, deren überlagerte Ausgangssignale das regenerierte n-äre Signal ergeben.

Bevor das n-äre Signal den Amplitudenentscheidern zugeführt wird, durchläuft es eine mit dem Symboltakt des n-ären Signales getaktete Abtaststufe, mit der zu den gewünschten Abtastzeitpunkten - nämlich in Augenmitte - Signalteile ausgeblendet werden.

In der zitierten Literaturstelle ist jedoch nicht angegeben, wie die Phasenlage des Symboltaktes zu beeinflussen ist, damit die Abtastung tatsächlich etwa in Augenmitte - also optimal - erfolgt. Besondere Schwierigkeiten treten dann auf, wenn sich die Augenöffnung eines zu regenerierenden Nutzsignales im Laufe der Übertragung ändern kann, so daß eine optimale Abtastung zu Zeitpunkten erfolgen muß, die von vornherein nicht festlegbar sind. Eine solche Veränderung der Augenöffnung tritt z.B. an der Schnittstelle S (CCITT-Empfehlung I.430 Section 3) des zukünftigen dienstintegrierten digitalen Fernmeldenetzes ISDN auf. Beim Nutzsignal handelt es sich in diesem Falle um ein Multiplexsignal, das aus den Signalen der Teilnehmerendeinrichtungen zusammengesetzt wird, deren Aktivitäten von einem Netzabschlußgerät synchronisiert werden. Beginnt eine Teilnehmerendeinrichtung zu senden, während eine andere schon ihr Sendesignal abgibt, so tritt im Gesamtsignal eine Verkleinerung der Augenöffnung ein, deren Größe von der unterschiedlichen Signallaufzeit zwischen Teilnehmerendeinrichtung und Netzabschlußgerät abhängt.

Der Erfindung liegt die Aufgabe zu grunde, eine Abtastschaltung der eingangs genannten Art anzugeben, durch die die optimale Abtastphasenlage laufend aus dem ternären Nutzsignal ermittelt wird.

Diese Aufgabe wird bei einer Schaltungsanordnung der eingangs genannten Art dadurch gelöst, daß das Ausgangssignal eines jeden Fensterkomparators mit einem zum Symboltakt des ternären Signales phasenstarren Takt der m-fachen Symboltaktfrequenz abgetastet wird,

daß die binären Abtastwerte durch jeweils ein Schieberegister mit mindestens m Stufen geschoben werden und der Inhalt der Schieberegister mit dem Symboltakt in jeweils einen Zwischenspeicher übernommen wird,

daß die Ausgänge der beiden Zwischenspeicher mit den Eingängen einer Logik verbunden sind und jeder Gruppe von k aufeinander folgender Speicherstellen des ersten Zwischenspeichers und der entsprechenden Gruppe des zweiten Zwischenspeichers ein Ausgang der Logik zugeordnet ist,

daß an diesem Ausgang eine binäre Eins anliegt, wenn eine der beiden Gruppen von Speicherstellen nur binären Einsen enthalten,

daß mit jeder binären Eins an einem Ausgang der Logik ein diesem Ausgang zugeordneter Zähler inkrementiert wird,

daß das Erreichen eines ersten vorbestimmten Standes eines jeden Zählers dann als binäre Eins in die Speicherstellen eines dritten Zwischenspeichers übernommen wird,

daß alle Zähler zurückgesetzt werden, wenn einer der Zähler einen zweiten, jedoch höheren vorbestimmten Stand erreicht hat,

daß alle Speicherstellen des dritten Zwischenspeichers mit den Eingängen einer Auswahlschaltung verbunden sind, die nur eine die an ihre Eingängen anliegenden Einsen an den zugeordneten Ausgang weitergibt,

daß mit den Signalen am Ausgang der Auswahlschaltung eine Gatter-Schaltung für einen der im ersten und einen der im zweiten Zwischenspeicher gespeicherten binären Abtastwerte durchlässig geschaltet wird.

Die erfindungsgemäße Anordnung zeichnet sich dadurch aus, daß sie nur aus digitalen Bausteinen besteht und daher ohne weiteres als integrierter Schaltkreis ausführbar ist.

Vorteilhafte Ausgestaltungen und Weiterbildungen der Erfindung sind den Unteransprüchen zu entnehmen.

Anhand der Figuren soll ein Ausführungsbeispiel der Erfindung näher erläutert werden.

Fig. 1 zeigt das Blockschaltbild eines Ausführungsbeispieles der Erfindung.

Fig. 2 und Fig. 3 zeigen den inneren Aufbau von Funktionsblöcken der Fig. 1.

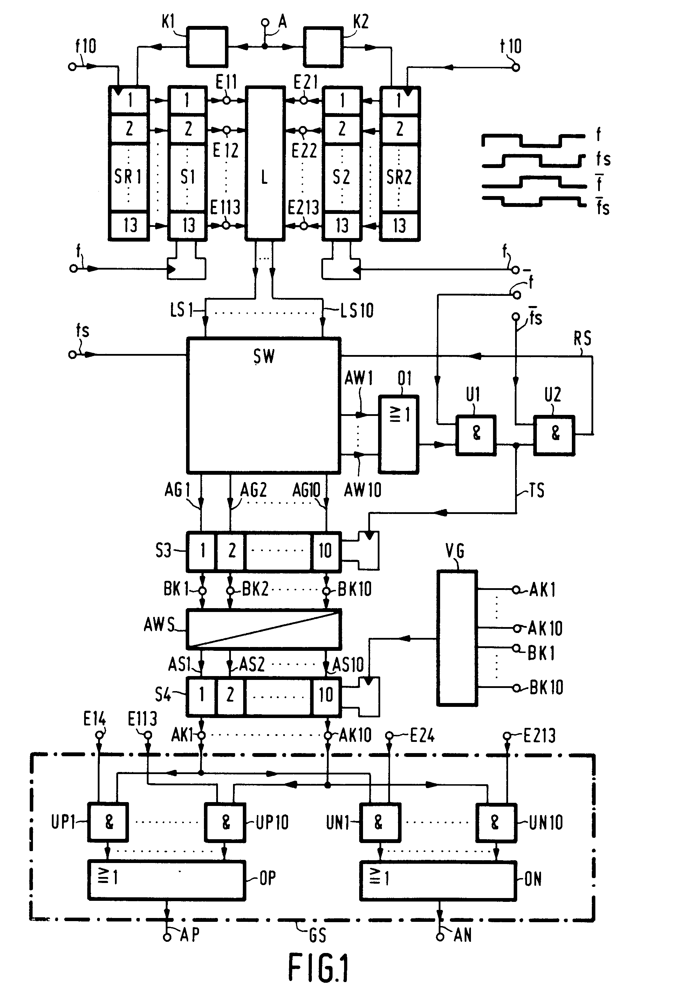

Nach Fig. 1 wird das zu regenerierende ternäre Signal - im Ausführungsbeispiel ein pseudoternäres AMI-kodiertes Signal A - zwei Fensterkomparatoren K1 und K2 zugeführt. Die positiven Impulse des Signales A fallen in das Fenster des Komparators K1 und die negativen in das Fenster des Komparators K2. Bei einem positiven Impuls liegt also am Ausgang des Komparators K1 eine binäre Eins an, während der Ausgang des Komparators K2 das einer binären Null entsprechende Potential annimmt.

Denkbar sind auch Ausführungsformen, bei denen diese und in der folgenden Beschreibung erwähnten Binärwerte durch ihre Komplemente ersetzt sind. Die gewählte Festlegung der Binärwerte ist jedoch für die Erfindung unwesentlich und dient nur ihrer einfacheren Verdeutlichung.

Die Binärwerte an den Ausgängen der Komparatoren K1 und K2 werden mit einem Takt f10 abgetastet, dessen Taktfrequenz das Zehnfache des zum Signal A gehörigen Symboltaktes f beträgt; im vorliegenden Beispiel ist also m = 10 gewählt. Für jeden Komparator ist ein Schieberegister SR1, SR2 vorgesehen, durch das die binären Abtastwerte mit dem Takt f10 geschoben und parallel mit dem Takt f in einen Zwischenspeicher S1, S2 übernommen werden. Die Phasenlage des Symboltaktes f, bezogen auf das Signal A, kann beliebig sein; deshalb ist es auch nicht erforderlich, daß der Takt f aus dem Signal A zurückgewonnen wird. Es reicht eine beliebige Taktquelle mit der nominellen Frequenz des zum Signal A gehörigen Symboltaktes. Die Takte f10 und f haben allerdings eine zeitunabhängiger Phasenrelation zueinander.

Die Anzahl der Stufen der Schieberegister SR1, SR2, die ebenso groß ist wie die Anzahl der binären Speicherzellen der Zwischenspeicher S1 und S2, ist so groß - nämlich 13 - gewählt, daß unabhängig von der Phasenlage des Taktes f 10 Gruppen zu je vier aufeinanderfolgende Abtastwerte - k ist also im vorliegenden Beispiel zu vier gewählt worden - darin Platz haben. Auf diese Weise wird sichergestellt, daß mit jedem Taktimpuls des Taktes f alle Abtastwerte eines Signalelementes, die in das Auge des Signales A fallen, als lückenlose Folge im Zwischenspeicher S1 oder S2 stehen. Außerdem ist unterstellt, daß mindestens vier Abtastwerte eines jeden Signalelementes in das Auge des Signales A fallen, die Augenbreite also mindestens 2/5 der nominellen Periodendauer des Symboltaktes f beträgt.

Zweck der weiteren Schaltungsteile ist nun unter anderem, automatisch festzustellen, wo sich innerhalb der in den Zwischenspeichern S1 und S2 gespeicherten Signalabschnitten das Auge des ternären Signales A befindet und mit jeder Taktflanke des Symboltaktes f einen der zum Auge gehörigen Abtastwerte vom Zwischenspeicher S2 zum Ausgang AP bzw. vom Zwischenspeicher S2 zum Ausgang AN weiterzuleiten.

Zur Feststellung der Lage des Auges werden die binären Einsen in den Zwischenspeichern S1 und S2 verwendet. Treten häufiger mit den Taktflanken des Taktes f an den gleichen vier aufeinanderfolgenden Speicherzellen der Zwischenspeicher S1 oder S2 binäre Einsen auf, so werden diese Stellen als die Augenmitte des Signales A angesehen. Mögliche Lage der Augenmitte ermittelt die Logik L, mit der der Zwischenspeicher S1 über die Anschlüsse E11 bis E113 bzw. der Zwischenspeicher S2 über die Anschlüsse E21 bis E213 verbunden ist.

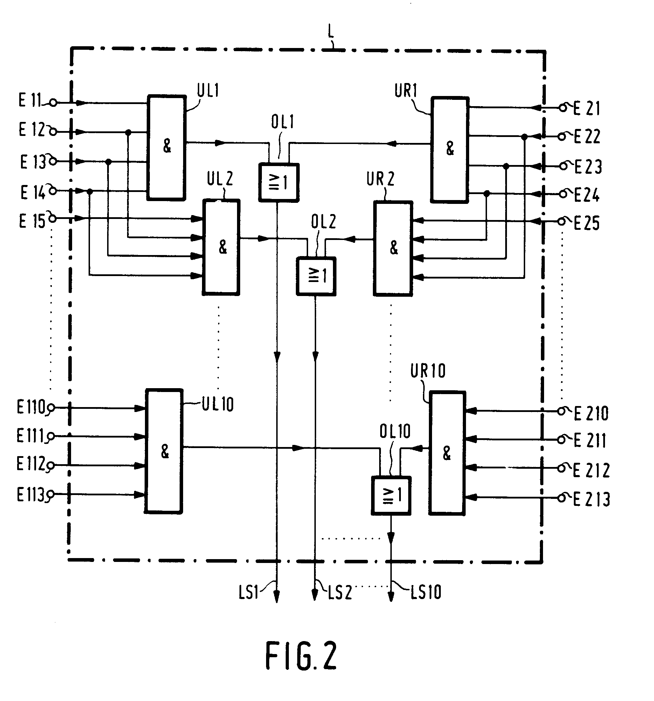

Der genaue Aufbau der Logik L ist in Fig. 2 gezeigt. Über die Anschlüsse E11 bis E14 sind die ersten vier Speicherstellen des Zwischenspeichers S1 mit den vier Eingängen eines UND-Gatters UL1 verbunden. Die Speicherzellen 2 bis 5 des Zwischenspeichers S1 sind über die Anschlüsse E12 bis E15 mit den Eingängen eines weiteren UND-Gatters UL2 verbunden und so fort bis zu den Speicherstellen 10 bis 13, die über die Anschlüsse E110 bis E113 mit den Eingängen einen zehnten UND-Gatters UL10 verbunden sind. Entsprechendes gilt für die Verbindung der Speicherstellen des Zwischenspeichers S2 über die Anschlüsse E21 bis E214 mit den UND-Gattern UR1 bis UR10.

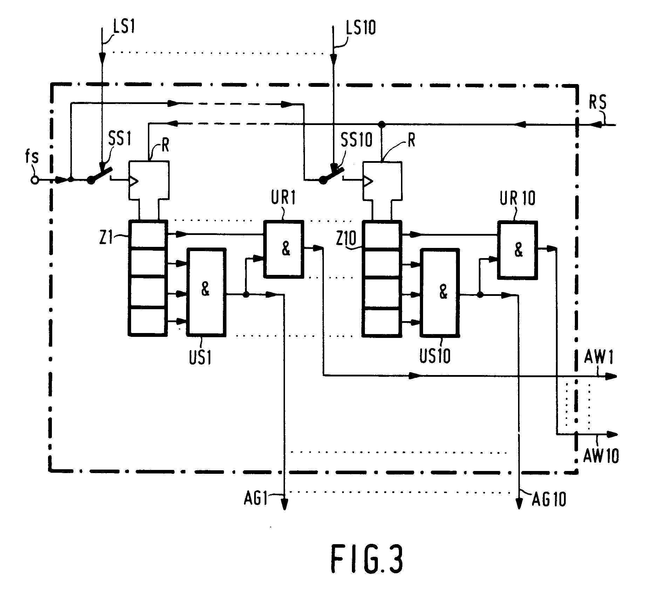

Die Ausgänge der UND-Gatter UL1 und UR1, die ein Gatterpaar bilden, sind an ein ODER-Gatter OL1 geführt. Am Ausgang dieses ODER-Gatters OL1 tritt eine binäre Eins auf, wenn in den ersten vier Speicherstellen des Zwischenspeichers S1 oder in den ersten vier Speicherstellen des Zwischenspeichers S2 nur binäre Einsen enthalten sind. Wiederum gilt entsprechendes für die UND-Gatterpaare UL2 und UR2 bis UL10 und UR10 und die ODER-Gatter OL2 bis OL10. Die Ausgänge der ODER-Gatter OL1 bis OL10 sind gleichzeitig die Ausgänge der Logik L, sie sind über Leitungen LS1 bis LS10 mit den Eingängen eines Schaltwerkes SW verbunden, mit dem gezählt wird, wie oft an den Ausgängen der ODER-Gatter OL1 bis OL10 binäre Einsen auftreten. Für diesen Zweck - Fig. 3 zeigt Einzelheiten des Schaltwerkes SW - sind 10 Zähler Z1 bis Z10 vorgesehen, von denen je einer einem der ODER-Gatter OL1 bis OL10 zugeordnet ist. Tritt am Ausgang eines dieser ODER-Gatter zu einem Taktzeitpunkt des Taktes f eine binäre Eins auf, so wird der zugeordnete Zähler um eine Zählereinheit inkrementiert. Zur Inkrementierung der Zähler Z1 bis Z10 sind Schalter SS1 bis SS10 vorgesehen, deren Steuereingänge mit je einer der Leitungen LS1 bis LS10 verbunden sind. Eine binäre Eins auf eine dieser Leitungen schließt den zugeordneten Schalter, über den dann ein Taktimpuls des Taktes fs dem Zähleingang des angeschlossenen Zählers zugeführt wird. Der Takt fs ist der um 90° phasenverschobene Symboltakt f; die Phasenverschiebung ist notwendig, damit signallaufzeiten nicht zu Fehlfunktionen führen. Die Phasenrelation aller beim Ausführungsbeispiel verwendeten Takte ist im oberen rechten Teil der Fig. 1 schematisch dargestellt.

Jeder der 4-stufigen Zähler Z1 bis Z10 des Schaltwerkes SW ist mit einer Abfrageschaltung versehen, die aus zwei UND-Gattern besteht. Mit dem ersten UND-Gatter US1 bis US10 wird eine UND-Verknüpfung der drei Stufen mit höchster Wertigkeit eines jeden Zählers Z1 bis Z10 vorgenommen. Am Ausgang der UND-Gatter US1 bis US10 erscheint eine binäre Eins, wenn der angeschlossene Zähler einen Stand von mindestens 14 erreicht hat. Diese binären Einsen werden über Leitungen AG1 bis AG10 an die Eingänge eines dritten Zwischenspeichers S3 mit zehn Speicherstellen geführt.

Am Ausgang des zweiten UND-Gatters UR1 bis UR10 einer jeden Abfrageschaltung tritt eine binäre Eins auf solange der angeschlossene Zähler auf seinem Höchststand, nämlich 15 steht.

Die Ausgänge der zweiten UND-Gatter UR1 bis UR10 sind über Leitungen AW1 bis AW10 an ein ODER-Gatter O1 mit zehn Eingängen geführt, an dessen Ausgang folglich dann eine binäre Eins auftritt, wenn mindestens einer der Zähler Z1 bis Z10 seinen Höchststand erreicht hat.

Zur Formung von Taktimpulsen wird das Ausgangssignal der ODER-Gatter O1 mit dem invertierten Symboltakt f durch ein UND-Gatter U1 verknüpft, mit dessen Ausgangssignal der Zwischenspeicher S3 getaktet wird, in den die Binärwerte auf den Leitungen AG1 bis AG10 übernommen werden. Nach dem Auftreten eines Taktimpulses auf einer Leitung TS zeigt eine binäre Eins in den Speicherstellen des Zwischenspeichers S3 an, welcher der Zähler Z1 bis Z10 den Stand 14 oder 15 erreicht hat. Ist dies z.B. beim Zähler Z10 der Fall, so heißt das, daß in den letzten vier Speicherstellen des Zwischenspeichers S1 oder in den letzten vier Speicherstellen des Zwischenspeichers S2 bei 14 oder 15 Taktimpulsen des Symboltaktes f nur binäre Einsen gestanden haben. Folglich gehören die Signalausschnitte, die in den letzten vier Speicherstellen der Zwischenspeicher S1 und S2 zwischengespeichert werden, zur Augenmitte des Signales A und es wird der in der Speicherstelle 13 des Zwischenspeichers S1 gespeicherte Abtastwert an den Ausgang AP und der in Speicherstelle 13 des Zwischenspeichers S2 gespeicherte Abtastwert an den Ausgang AN der Schaltung nach Fig. 1 gelegt.

Zur Durchführung dieses Vorganges folgt auf den Zwischenspeicher S3 eine Auswahlschaltung AWS, deren Eingänge über Klemmen BK1 bis BK10 mit den Ausgängen der Stufe 1 bis 10 des Zwischenspeichers S3 verbunden sind. Jedem Eingang der Auswahlschaltung AWS ist ein Ausgang zugeordnet. Liegt an mehreren Eingängen der Auswahlschaltung AWS eine binäre Eins an, so wird diese nur bei einem Eingang an den zugeordneten Ausgang weitergeleitet, während an allen anderen Ausgängen eine binäre Null anliegt. Die Binärwerte an den Ausgängen der Auswahlschaltung werden über Leitungen AS1 bis AS10 an die Speicherstellen 1 bis 10 einer vierten getakteten Zwischenspeichers S4 geführt, dessen Funktion weiter unten genauer erläutert wird.

Ist nun z.B. in der zehnten Speicherstelle des Zwischenspeichers S4 eine binäre Eins gespeichert - alle anderen Speicherstellen enthalten dann binären Nullen - so werden die UND-Gatter UP10 und UN10 einer an den Zwischenspeicher S4 angeschlossenen Gatterschaltung GS geöffnet. Im Falle des Gatters UP10, dessen zweiter Eingang mit der Klemme E113 verbunden ist, gelangt die in der dreizehnten Speicherstelle des Zwischenspeichers S1 gespeicherte Information an den Gatterausgang und über ein ODER-Gatter OP an den Ausgang AP. Im Falle des Gatters UN10, dessen zweiter Eingang mit der Klemme E213 verbunden ist, gelangt die in der dreizehnten Speicherstelle des Zwischenspeichers S2 gespeicherte Information an den Gatterausgang und über ein ODER-Gatter ON an den Ausgang AN.

Enthält eine andere als die zehnte Speicherstelle des Zwischenspeichers S4 die binäre Eins, so wird auch ein anderes der UND-Gatter UP1 bis UP10, bzw. UN1 bis UN10 der Gatterschaltung GS geöffnet, und es werden die gespeicherten Binärwerte anderer Speicherstellen der Zwischenspeicher S1 und S2 an die Ausgänge AP und AN zur weiteren Verarbeitung geleitet.

Ist mit Hilfe des Schaltwerkes SW und dessen Zähler Z1 bis Z10 die Lage des Auges gefunden worden, so wird die Suche wiederholt, indem alle Zähler gelöscht werden, sobald ein Zähler seinen Höchststand erreicht hat. Der Löschimpuls für die Zähler wird aus dem Ausgangssignal des UND-Gatters U1 und einem Takt $\overline{fs}$ gewonnen, der gegenüber dem Symboltakt f um 270° phasenverschoben ist. Beide Signale werden einem weiteren UND-Gatter U2 zugeführt, dessen Ausgang über eine Leitung RS mit den Rücksätzeingängen R sämtlicher Zähler Z1 bis Z10 verbunden ist.

Wie oben schon angedeutet, legt der Inhalt des Zwischenspeichers S4 die Speicherstellen der Zwischenspeicher S1 und S2 fest, deren Binärwerte an die Ausgänge AP und AN weitergeleitet werden; er bestimmt also die Abtastphasenlage des Signales A. Wird z.B. das Auge des Signales A im Laufe der Zeit vergrößert, so ist die vor der Augenvergrößerung gewählte Abtastphasenlage ebenso geeignet wie z.B. eine neue Phasenabtastlage, die sich allein aufgrund der Funktionsweise der Auswahlschaltung AWS ergeben würde. Um unnötige Sprünge in der Abtastphasenlage zu vermeiden, ist ein Vergleicher VG mit 20 Eingängen vorgesehen, die mit den Klemmen AK1 bis AK10 und BK1 bis BK10 verbunden sind. Der Vergleicher VG gibt nur dann einen Taktimpuls an den Zwischenspeicher S4 ab, wenn die Abtastphasenlage vor einer Änderung des Auges nicht in den zulässigen Abtastphasenlagen nach Änderung des Auges enthalten ist, d.h., wenn keine der UND-Verknüpfungen zwischen den beiden Signalen an den Klemmen AK1 und BK1 bis AK10 und BK10 den Wert Eins annimmt. Nur in diesem Fall werden mit dem Taktimpuls des Vergleichers VG die am Ausgang der Auswahlschaltung AWS anliegenden Binärwerte in den Zwischenspeicher S4 übernommen, wobei die Speicherstelle, in der die einzige binäre Eins gespeichert ist, die neue Abtastphasenlage festlegt.

**Patentansprüche**

1. Schaltungsanordnung zur Abtastung eines ternären Signales, bei der das ternäre Signal an die Eingänge zweier Fensterkomparatoren (K1, K2) geführt ist und seine größten Amplituden in das Fenster des ersten und seine kleinsten Amplituden in das Fenster des zweiten Fensterkomparators fallen,
dadurch gekennzeichnet
   - daß das Ausgangssignal eines jeden Fensterkomparators (K1, K2) mit einem zum Symboltakt des ternären Signales phasenstarren Takt (f10) der m-fachen Symboltaktfrequenz abgetastet wird,
   - daß die binären Abtastwerte durch jeweils ein Schieberegister (SR1, SR2) mit mindestens m Stufen geschoben werden und der Inhalt der Schieberegister (SR1, SR2) mit dem Symboltakt (f) in jeweils einen Zwischenspeicher (S1,S2) übernommen wird,
   - daß die Ausgänge der beiden Zwischenspeicher (S1, S2) mit den Eingängen einer Logik (L) verbunden sind und jeder Gruppe von k aufeinanderfolgender Speicherstellen des ersten Zwischenspeichers (S1) und der entsprechenden Gruppe des zweiten Zwischenspeichers (S2) ein Ausgang (LS1...LS10) der Logik (L) zugeordnet ist,
   - daß an diesem Ausgang (LS1...LS2) eine binäre Eins anliegt, wenn eine der beiden Gruppen von Speicher stellen nur binäre Einsen enthalten,
   - daß mit jeder binären Eins an einem Ausgang (LS1...LS10) der Logik (L) ein diesem Ausgang zugeordneter Zähler (Z1...Z10) inkrementiert wird,
   - daß das Erreichen eines ersten vorbestimmten Standes eines jeden Zählers (Z1...Z10) dann als binäre Eins in die Speicherstellen eines dritten Zwischenspeichers (S3) übernommen wird,
   - daß alle Zähler (Z1...Z10) zurückgesetzt werden, wenn einer der Zähler (Z1...Z10) einen zweiten, jedoch höheren vorbestimmten Stand erreicht hat,

   - daß alle Speicherstellen des dritten Zwischenspeichers (S3) mit den Eingängen einer Auswahlschaltung (AWS) verbunden sind, die nur eine der an ihren Eingängen anliegenden Einsen an den zugeordneten Ausgang weitergibt,
   - daß mit den Signalen am Ausgang der Auswahlschaltung (AWS) eine Gatter-Schaltung (GS) für einen der im ersten (S1) und einen der im zweiten (S2) Zwischenspeicher gespeicherten binären Abtastwerte durchlässig geschaltet wird.

2. Anordnung nach Anspruch 1, dadurch gekennzeichnet, daß zwischen die Auswahlschaltung (AWS) und die Gatter-Schaltung (GS) ein vierter getakteter Zwischenspeicher (S4) geschaltet ist, der von einem Vergleicher (VG) getaktet wird, und daß der Vergleicher (VG) nur dann einen Taktimpuls abgibt, wenn die Binärwerte an den Ausgängen des dritten Zwischenspeichers (S3) mit den Binärwerten an den entsprechenden Ausgängen des vierten Zwischenspeichers (S4) an keiner Stelle übereinstimmen.

3. Anordnung nach Anspruch 1 oder 2, dadurch gekennzeichnet, daß m den Wert 10 hat, die Schieberegister (SR1, SR2) jeweils 13 Stufen aufweisen und der erste und der zweite Zwischenspeicher (S1, S2) ebenfalls aus 13 Speicherstellen bestehen.

4. Anordnung nach Anspruch 3, dadurch gekennzeichnet, daß k den Wert 4 hat, und die Logik (L) aus zehn Paaren von UND-Gattern (UL1, UR1...UL10,UR10) mit vier Eingängen besteht, wobei die vier Eingänge des ersten UND-Gatters (UL1...UL10) eines Paares mit vier aufeinanderfolgenden Ausgängen des ersten Zwischenspeichers (S1), die vier Eingänge des zweiten UND-Gatters (UR1...UR10) mit entsprechenden Ausgängen des zweiten Zwischenspeichers (S2) verbunden sind und daß die Ausgänge eine jeden Paares von UND-Gattern durch ein ODER-Gatter (OL1...OL10) verknüpft sind, dessen Ausgang einen Ausgang (LS1...LS10) der Logik bildet.

5. Anordnung nach Anspruch 4, dadurch gekennzeichnet, daß alle Zähler (Z1...Z10) identisch sind und der erste vorbestimmte Stand der um eine Zähleinheit verminderte Höchststand eines jeden Zählers ist.

6. Anordnung nach Anspruch 5, dadurch gekennzeichnet, daß alle Zähler (Z1...Z10) 4-stufig sind.

7. Anordnung nach Anspruch 6, dadurch gekennzeichnet, daß zur Taktung des dritten Zwischenspeichers (S3) die UND-Verknüpfung (US1, UR1...US10, UR10) aller Stufen eines jeden Zählers an je einen Eingang eines ersten ODER-Gatters (01) geführt ist, der Ausgang dieses ODER-Gatters an einen Eingang eines ersten UND-Gatters (U1) mit zwei Eingängen geführt ist, der andere Eingang des ersten UND-Gatters (U1) mit dem invertierten Symboltakt (f) beaufschlagt ist und daß der Ausgang des ersten UND-Gatters (U1) mit dem Takteingang des dritten Zwischenspeichers (S3) verbunden ist.

8. Schaltungsanordnung nach Anspruch 7, dadurch gekennzeichnet, daß zur Löschung aller Zähler (Z1...Z10) der Ausgang des ersten UND-Gatters (U1) an einen Eingang eines zweiten UND-Gatters (U2) mit zwei Eingängen geführt ist, daß dem zweiten Eingang zweiten UND-Gatters (U2) der um 270° verschobene Symboltakt (fs̄) zugeführt ist und daß der Ausgang des zweiten UND-Gatters (U2) an die Rücksetzeingänge (R) der Zähler (Z1...Z10) geführt ist.

9. Schaltungsanordnung nach Anspruch 3, dadurch gekennzeichnet, daß die Gatter-Schaltung (GS) aus zwei Sätzen zu je zehn UND-Gattern (UP1...UP10, UN1...UN10) mit zwei Eingängen besteht, daß je ein Eingang eines UND-Gatters (UP1...UP10) des ersten Satzes mit je einem Ausgang (E14...E113) von zehn aufeinanderfolgenden Speicherstellen des ersten Zwischenspeichers (S1) verbunden ist, daß je ein Eingang eines UND-Gatters (UN1...UN10) des zweiten Satzes mit je einem Ausgang (E24...E213) von zehn aufeinanderfolgenden Speicherstellen des zweiten Zwischenspeichers (S2) verbunden ist, daß die zweiten Eingänge der UND-Gatter des ersten und des zweiten Satzes mit je einem Ausgang des vierten Zwischenspeichers (S4) verbunden sind, daß die Ausgänge der UND-Gatter (UP1...UP10) des ersten Satzes an die Eingänge eines ersten ODER-Gatters (OP) mit zehn Eingängen geführt sind und daß die Ausgänge der UND-Gatter (UN1...UN10) des zweiten Satzes an die Eingänge eines zweiten ODER-Gatters (ON) mit zehn Eingängen geführt sind.

**Claims**

1. Circuit arrangement for sampling a ternary signal, in which the ternary signal is applied to the inputs of two window comparators (K1, K2) and its largest amplitudes fall within the window of the first window comparator and its smallest amplitudes within the window of the second window comparator, characterized, in that
   - the output signal of each window comparator (K1, K2) is sampled with a clock signal (f10) having a rate of m times the symbol clock rate and having a fixed phase relation to the symbol clock of the ternary signal;
   - the respective binary samples are shifted through a shift register (SR1, SR2) which has at least m stages and the contents of the respective shift registers (SR1, SR2) are transferred to respective buffers (S1, S2) at the symbol clock rate (f);
   - the outputs of the two buffers (S1, S2) are connected to the inputs of a logic circuit (L) and an output (LS1...LS10) of the logic circuit (L) is assigned to each group of k consecutive memory locations of the first buffer (S1) and the corresponding group of the second buffer (S2);
   - a binary one is present at this output (LS1...LS2) when one of said two groups of memory locations contains only binary ones;
   - each binary one at an output (LS1...LS10) of the logic circuit (L) increments a counter (Z1...Z10) assigned to this output;
   - when one of these counters (Z1...Z10) reaches a first predetermined count, this count is then transferred to the memory locations of a third buffer (S3) as a binary one;
   - all the counters (Z1...Z10) are reset when one of the counters (Z1...Z10) has reached a second, but higher predetermined count;
   - all the memory locations of the third buffer (S3) are connected to the inputs of a selection circuit (AWS) which conveys only one of the ones present at its inputs to the associated output;
   - a gate circuit (GS) is rendered conductive for one of the binary samples stored in the first buffer (S1) and for one of the binary samples stored in the second buffer (S2) by means of the signals at the output of the selection circuit (AWS).

2. Arrangement as claimed in Claim 1, characterized in that a fourth clocked buffer (S4) clocked by a comparator (VG) is inserted between the selection circuit (AWS) and the gate circuit (GS), and in that the comparator (VG) produces a clock pulse only when the binary values at the outputs of the third buffer (S3) do not match at any location the binary values at the corresponding outputs of the fourth buffer (S4).

3. Arrangement as claimed in Claim 1 or 2, characterized in that m has the value of 10, the shift registers (SR1, SR2) have each 13 stages and the first and second buffers (S1, S2) likewise comprise 13 memory locations.

4. Arrangement as claimed in Claim 3, characterized in that k has the value of 4, and the logic circuit (L) comprises ten pairs of AND-gates (UL1, UR1...UL10, UR10) having four inputs, the four inputs of the first AND-gates (UL1...UL10) of a pair are connected to four consecutive outputs of the first buffer (S1), the four inputs of the second AND-gates (UR1...UR10) are connected to corresponding outputs of the second buffer (S2) and in that the outputs of each pair of AND-gates are combined through an OR-gate (OL1...OL10), whose respective outputs constitute outputs (LS1...LS10) of the logic circuit.

5. Arrangement as claimed in Claim 4, characterized in that all the counters (Z1...Z10) are identical and the first predetermined count is the highest count less one count unit of each counter.

6. Arrangement as claimed in Claim 5, characterized in that all counters (Z1...Z10) are 4-stage counters.

7. Arrangement as claimed in Claim 6, characterized in that for clocking the third buffer (S3) the AND-combination (US1, UR1...US10, UR10) of all the stages of each of the counters is connected to each input of a first OR-gate (01), the output of this OR-gate is connected to an input of a first AND-gate (U1) having two inputs, the other input of the first AND-gate (U1) carries the inverted clock symbol (f) and in that the output of the first AND-gate (U1) is connected to the clock input of the third buffer (S3).

8. Circuit arrangement as claimed in Claim 7, characterized in that for resetting all the counters (Z1...Z10) to zero, the output of the first AND-gate (U1) is applied to an input of a second AND-gate (U2) which has two inputs, in that the other input of the second AND-gate (U2) is supplied with the symbol clock ($\overline{fs}$) shifted through 270° and in that the output of the second AND-gate (U2) is applied to the reset inputs (R) of the counters (Z1...Z10).

9. Circuit arrangement as claimed in Claim 3, characterized in that the gate circuit (GS) is constituted by two sections each having ten AND-gates (UP1...UP10, UN1...UN10) which have first and second inputs, in that each first input of an AND-gate (UP1...UP10) of the first section is connected to a respective output (E14...E113) of ten consecutive memory locations of the first buffer (S1), in that each first input of an AND-gate (UN1...UN10) of the second section is connected to a respective output (E24...E213) of ten consecutive memory locations of the second buffer (S2), in that the second inputs of the AND-gates of the first and second sections are each connected to respective outputs of the fourth buffer (S4), in that the outputs of the AND gates (UP1...UP10) of the first section are connected to the inputs of a first OR-gate (OP) which have ten inputs and in that the outputs of the AND-gates (UN1...UN10) of the second section are connected to the inputs of a second OR-gate (ON) which has ten inputs.

**Revendications**

1. Montage de circuit pour l'échantillonnage d'un signal ternaire, dans lequel le signal ternaire est appliqué aux entrées de deux comparateurs à fenêtre (K1, K2), les plus grandes amplitudes de ce signal tombant dans la fenêtre du premier et les plus petites amplitudes, dans la fenêtre du second comparateur à fenêtre, caractérisé en ce

que le signal de sortie de chaque comparateur à fenêtre (K1, K2) est échantillonné à un rythme (f10) rigide en phase par rapport au rythme de symboles du signal ternaire de m fois la fréquence de base de symboles,

que les valeurs d'échantillonnage binaires traversent chaque fois un registre à décalage (SR1, SR2) comportant au moins m étages et le contenu du registre à décalage (SR1, SR2) est repris, au rythme de symboles (f), chaque fois dans une mémoire intermédiaire (S1, S2),

que les sorties des deux mémoires intermédiaires (S1, S2) sont connectées aux entrées d'une unité logique (L) et chaque groupe de k emplacements de mémoire successifs de la première mémoire intermédiaire (S1) et du groupe correspondant de la seconde mémoire intermédiaire (S2) est associé à une sortie (LS1 ... LS10) de l'unité logique (L),

que cette sortie (LS1 ... LS2) présente un un binaire lorsqu'un des deux groupes d'emplacements de mémoire ne contient que des uns binaires,

qu'à chaque un binaire sur une sortie (LS1 ... LS10) de l'unité logique (L), un compteur (Z1 ... Z10) associé à cette sortie est incrémenté,

que l'arrivée de chaque compteur (Z1 ... Z10) à un premier état prédéterminé est repris comme un binaire dans les emplacements de mémoire d'une troisième mémoire intermédiaire,

que tous les compteurs (Z1 ... Z10) sont remis à zéro lorsqu'un des compteurs a atteint un second état prédéterminé, mais supérieur,

que tous les emplacements de mémoire de la troisième mémoire intermédiaire (S3) sont connectés aux entrées d'un circuit de sélection (AWS) qui ne transmet à la sortie associée qu'un des uns présents sur ses entrées,

qu'à l'aide des signaux à la sortie du circuit de sélection (AWS), un circuit-porte (GS) est connecté en sens passant pour l'une des valeurs d'échantillonnage binaires stockées dans la première mémoire intermédiaire (S1) et pour l'une de celles stockées dans la seconde mémoire intermédiaire (S2).

2. Montage suivant la revendication 1, caractérisé en ce qu'entre le circuit de sélection (AWS) et le circuit-porte (GS) est connectée une quatrième mémoire intermédiaire rythmée (S4) qui est rythmée par un comparateur (VG), et que le comparateur (VG) ne fournit une impulsion d'horloge que lorsque les valeurs binaires aux sorties de la troisième mémoire intermédiaire (S3) ne concordent en aucun endroit avec les valeurs binaires aux sorties correspondantes de la quatrième mémoire intermédiaire (S4).

3. Montage suivant la revendication 1 ou 2, caractérisé en ce que m a la valeur 10, les registres à décalage (SR1, SR2) comportent chacun treize étages et la première ainsi que la deuxième mémoire intermédiaire (S1, S2) sont également constituées de treize emplacements de mémoire.

4. Montage suivant la revendication 3, caractérisé en ce que k a la valeur 4 et l'unité logique (L) est constituée de dix paires de portes ET (UL1, UR1 ... UL10, UR10) à quatre entrées, les quatre entrées de la première porte ET (UL1 ... UL10) d'une paire étant connectées à quatre sorties successives de la première mémoire intermédiaire (S1), les quatre entrées de la deuxième porte ET (UR1 ... UR10) étant connectées aux sorties correspondantes de la deuxième mémoire intermédiaire (S2) et les sorties de chaque paire de portes ET étant combinées par une porte OU (OL1 ... OL10), dont la sortie forme une sortie (LS1 ... LS10) de l'unité logique.

5. Montage suivant la revendication 4, caractérisé en ce que tous les compteurs (Z1 ... Z10) sont identiques et la première position prédéterminée est la position maximale de chaque compteur diminuée d'une unité de comptage.

6. Montage suivant la revendication 5, caractérisé en ce que tous les compteurs (Z1 ... Z10) sont à quatre étages.

7. Montage suivant la revendication 6, caractérisé en ce que, pour rythmer la troisième mémoire intermédiaire (S3), la combinaison ET (US1, UR1 ... US10, UR10) de tous les étages de chaque compteur est appliquée chaque fois à une entrée d'une première porte OU (01), la sortie de cette porte OU est amenée à une entrée d'une première porte ET (U1) à deux entrées, l'autre entrée de la première porte ET (U1) est alimentée au moyen du rythme de symboles (f) inversé et que la sortie de la première porte ET (U1) est connectée à l'entrée d'horloge de la troisième mémoire intermédiaire (S3).

8. Montage de circuit suivant la revendication 7, caractérisé en ce que, pour effacer tous les compteurs (Z1 ... Z10), la sortie de la première porte ET (U1) est appliquée à une entrée d'une seconde porte ET (U2) à deux entrées, qu'à la seconde entrée de la seconde porte ET (U2) est appliqué le rythme de symboles ($\overline{fs}$) décalé de 270° et que la sortie de la seconde porte ET (U2) est appliquée aux entrées de remise à zéro (R) des compteurs (Z1 ... Z10).

9. Montage de circuit suivant la revendication 3, caractérisé en ce que le circuit-porte (GS) est formé de deux jeux de chacun dix portes ET (UP1 ... UP10, UN1 ... UN10) à deux entrées, que chaque entrée d'une porte ET (UP1 ... UP10) du premier jeu est connectée chaque fois à une sortie (E14 ... E113) de dix emplacements de mémoire successifs de la première mémoire intermédiaire (S1), que chaque entrée d'une porte ET (UN1 ... UN10) du second jeu est connectée chaque fois à une sortie (E24 ... E213) de dix emplacements de mémoire successifs de la deuxième mémoire intermédiaire (S2), que les secondes entrées des portes ET du premier et du second jeu sont connectées chaque fois à une sortie de la quatrième mémoire intermédiaire (S4), que les sorties des portes ET (UP1 ... UP10) du premier jeu sont appliquées aux entrées d'une première porte OU (OP) à dix entrées et que les sorties des portes ET (UN1 ... UN10) du second jeu sont appliquées aux entrées d'une seconde porte OU (ON) à dix entrées.

FIG.1

FIG.2

FIG.3